# EUROPEAN PATENT APPLICATION

(11) **EP 4 797 243 A1**
(43) Date of publication of application: **26.08.2026**
(21) Application number: 25828078.3
(22) Date of filing: 26.09.2025
(51) Int. Cl.: G09B 9/00

(54) **ENERGY STORAGE TRAINING AID**

(30) Priority: 30.12.2024 CN 202423289073 U
(71) Applicant: Contemporary Amperex Technology Co., Limited, Ningde, Fujian 352100 (CN)
(72) Inventor: KONG, Chunfang, Ningde, Fujian 352100 (CN)
(74) Representative: Ziebig Hengelhaupt Intellectual Property Attorneys Patentanwaltskanzlei PartGmbB
(86) International application number: PCT/CN2025/124536
(87) International publication number: WO 2026/144327

(57) **Abstract**

This application discloses an energy storage practical training teaching aid. The energy storage practical training teaching aid includes an energy storage device, a control device, and a test panel; where the energy storage device includes a plurality of battery packs, each battery pack including a plurality of simulated battery cells connected in series; the test panel includes a measurement terminal unit, where the measurement terminal unit and the control device are both electrically connected to each simulated battery cell, and the measurement terminal unit is connected in parallel with the control device; the measurement terminal unit is configured to connect to an external measurement device to collect electrical parameters between two target simulated battery cells connected to the external measurement device; and the control device is configured to control one or more target simulated battery cells in the energy storage device to output a target required voltage in a simulated manner. The control device is used to perform voltage simulation on the simulated battery cells in the energy storage device, thereby simulating the voltage output of physical battery cells. In this way, the maintenance cost of the energy storage practical training teaching aid is reduced and the safety and service life of the energy storage practical training teaching aid are improved.

## Description

### CROSS-REFERENCE TO RELATED APPLICATIONS

This application claims the priority of Chinese Patent Application No. 202423289073.5, filed on December 30, 2024 and entitled "ENERGY STORAGE PRACTICAL TRAINING TEACHING AID," which is incorporated herein by reference in its entirety.

### TECHNICAL FIELD

This application relates to the field of battery technologies, and specifically to an energy storage practical training teaching aid.

### BACKGROUND

As an emerging automotive sector, new energy vehicles have experienced relatively rapid development in recent years. During this period, the demand for cultivating talents that match this development has also been increasing. As the core power source of new energy vehicles, technical training for batteries of new energy vehicles is particularly important. Therefore, there is an urgent need to provide a battery practical training teaching aid to facilitate the learning of batteries by students and improve the teaching experience and quality.

Existing energy storage practical training teaching aids generally adopt physical battery cells for teaching purposes. However, physical battery cells have characteristics of self-discharge and inconsistent single-cell discharge. During long-term storage, professional personnel are required to conduct timely maintenance; otherwise, single-cell imbalance will occur. In severe cases, phenomena such as swelling and electrolyte leakage will appear, which significantly reduce the safety and service life of the energy storage practical training teaching aid.

### SUMMARY OF THE INVENTION

In view of the above issues, this application provides an energy storage practical training teaching aid to address the problems of low safety and short service life associated with the use of physical battery cells in current energy storage practical training teaching aids.

In a first aspect, this application provides an energy storage practical training teaching aid, the energy storage practical training teaching aid including: an energy storage device, a control device, and a test panel; where the energy storage device includes a plurality of battery packs, each battery pack including a plurality of simulated battery cells connected in series; the test panel includes a measurement terminal unit, the measurement terminal unit and the control device being both electrically connected to each simulated battery cell, and the measurement terminal unit being connected in parallel with the control device; the measurement terminal unit is configured to connect to an external measurement device to collect electrical parameters between two target simulated battery cells connected to the external measurement device; and the control device is configured to control one or more target simulated battery cells in the energy storage device to output a target required voltage in a simulated manner.

For the energy storage practical training teaching aid designed as described above, this solution adopts simulated battery cells without injected electrolyte. The control device is used to perform voltage simulation on the simulated battery cells in the energy storage device, thereby simulating the voltage output of physical battery cells. This effectively avoids the problems existing in physical battery cells, including characteristics of self-discharge and inconsistent single-cell discharge. These problems would otherwise require professional personnel to conduct timely maintenance during long-term storage; if such maintenance is not performed, single-cell imbalance will occur. In severe cases, phenomena such as swelling and electrolyte leakage will appear, which significantly reduce the safety and service life of the energy storage practical training teaching aid. In this way, the maintenance cost of the energy storage practical training teaching aid is reduced, and the safety and service life of the energy storage practical training teaching aid are improved. Additionally, the energy storage practical training teaching aid designed in this solution is equipped with a test panel. A measurement terminal unit is reserved on the test panel, and external measurement devices can be connected via the measurement terminal unit to measure the voltage parameter information of any two simulated battery cells, thereby achieving the purpose of measurement practical training teaching.

In some embodiments, the energy storage device further includes a cooling unit and a control cabinet; where the control cabinet is electrically connected to the cooling unit as well as to the simulated battery cells of each battery pack, and the cooling unit is connected to each battery pack via cooling pipes; and the control cabinet is configured to control the cooling unit to cool a target battery pack through the cooling pipes and to acquire voltage information and temperature information of each simulated battery cell.

In the above embodiment, a control cabinet and a cooling unit are provided in the energy storage device of this solution. When the energy storage device performs high-power discharge, the cooling unit can promptly dissipate heat generated by the battery pack, which stabilizes parameters such as output voltage and current of the battery, thereby improving the reliability and safety of the battery system.

In some embodiments, the energy storage device further includes an energy storage product cabinet; where the energy storage product cabinet includes a plurality of accommodation spaces, with the plurality of battery packs, the cooling unit, and the control cabinet disposed within the plurality of accommodation spaces.

In some embodiments, the control device includes an input device and a battery voltage simulation device; where the battery voltage simulation device includes an isolation connection unit, a control unit, and a conversion and output unit; an input terminal of the isolation connection unit is electrically connected to an input device, an output terminal of the isolation connection unit is electrically connected to an input terminal of the control unit, an output terminal of the control unit is electrically connected to an input terminal of the conversion and output unit, and an output terminal of the conversion and output unit is electrically connected to the simulated battery cell; the isolation connection unit is configured to: electrically isolate the control unit from the input device, receive a target required voltage signal transmitted by the input device, and transmit the target required voltage signal to the control unit; the control unit is configured to output a pulse modulation signal with a target duty cycle to the conversion and output unit in response to the target required voltage signal, where different required voltage signals correspond to pulse modulation signals with different duty cycles; and the conversion and output unit is configured to convert the pulse modulation signal with the target duty cycle into a corresponding voltage simulation signal, the voltage simulation signal representing the target required voltage that is output by the connected simulated battery cell in a simulated manner.

In the above embodiment, the control unit stores associations between different required voltage signals and corresponding duty cycles. In this way, when different required voltage signals are received, a pulse modulation signal with the duty cycle corresponding to the required voltage can be output based on the required voltage signal. After digital-to-analog conversion of the pulse modulation signal, the simulated battery voltage can be output. Furthermore, the adjustment of different simulated battery voltages can be achieved through pulse modulation signals with different duty cycles, which enables high-precision simulation and adjustment of the battery voltage. This meets various application scenarios with high requirements for battery voltage accuracy, such as teaching experiments.

In some embodiments, the conversion and output unit includes at least one digital-to-analog conversion group; where each digital-to-analog conversion group includes one digital-to-analog converter and one operational amplifier, an input terminal of the digital-to-analog converter of each digital-to-analog conversion group is electrically connected to an output terminal of the control unit, an output terminal of the digital-to-analog converter of each digital-to-analog conversion group is connected to an input terminal of the operational amplifier of the corresponding digital-to-analog conversion group, and an output terminal of each operational amplifier is configured to electrically connect to one simulated battery cell; the digital-to-analog converter is configured to convert the pulse modulation signal with the target duty cycle into a corresponding voltage simulation signal and transmit the voltage simulation signal to the operational amplifier; and the operational amplifier is configured to amplify the voltage simulation signal and output the amplified voltage simulation signal to make the corresponding connected simulated battery cell output the target required voltage.

In some embodiments, the digital-to-analog conversion group is provided in plurality; and each digital-to-analog conversion group is connected to a corresponding simulated battery cell.

In the above embodiment, the control unit designed in this solution can connect a plurality of digital-to-analog conversion groups simultaneously. This enables one control unit to simulate and adjust the voltage of a plurality of simulated battery cells simultaneously, thereby reducing the spatial distribution of components and saving the costs of component resources when voltage simulation is performed for the plurality of simulated battery cells.

In some embodiments, the control device further includes a display control unit, a storage unit, and a display device; where the display control unit is electrically connected to the input device, the storage unit, and the display device, separately; and the display control unit is configured to: respond to a circuit diagram query request input by the input device, acquire a circuit topology diagram of the energy storage device stored in the storage unit, and display the circuit topology diagram of the energy storage device on the display device; where the storage unit pre-stores the circuit topology diagram of the energy storage device.

In the above embodiment, the storage unit stores a circuit topology diagram that matches the physical energy storage device. During the teaching process, the circuit topology diagram can be displayed through the control device, thereby facilitating teaching and analysis of the circuit topology diagram.

In some embodiments, the measurement terminal unit includes a plurality of measurement terminals, with each measurement terminal electrically connected to a corresponding simulated battery cell via a measurement line.

In some embodiments, the test panel further includes a fault setting unit; where the fault setting unit includes a plurality of fault terminals, with one fault terminal provided on a circuit connection line between each simulated battery cell and the control device; and the fault terminal is configured to conduct the corresponding connected simulated battery cell and the control device when in a closed state and to disconnect the corresponding connected simulated battery cell from the control device when in an open state.

In the above embodiment, through the arrangement of fault terminals in this solution, various fault types can be set in the energy storage practical training teaching aid designed in this solution. The fault types are comprehensive, which meets the teaching needs and aligns with real-world work scenarios. Moreover, the assessment difficulty can also be appropriately adjusted based on different teaching objects and teaching content.

In some embodiments, the test panel further includes a bench, where the bench includes a first panel and a second panel opposite the first panel, the measurement terminal unit is disposed on the first panel, and the fault setting unit is disposed on the second panel.

In the above embodiment, this solution designs that the name and pin number of a simulated battery cell corresponding to each measurement terminal can be marked at the position of this measurement terminal on the first panel. Additionally, corresponding markings may also be made at the position of each fault terminal in the fault setting unit on the second panel. This ensures consistency with the physical objects and the original equipment manufacturer circuit diagram, thereby facilitating quick lookup and circuit analysis and improving practical training efficiency.

The above description is only an overview of the technical solution of this application. To provide a clearer understanding of the technical means of this application and enable implementation in accordance with the contents of the specification, and to make the above and other objectives, features, and advantages of this application more apparent and understandable, specific embodiments of this application are provided below.

### DESCRIPTION OF THE DRAWINGS

By reading the detailed description of the preferred embodiments below, various other advantages and benefits will become clear to those skilled in the art. The accompanying drawings are provided solely for the purpose of illustrating the preferred embodiments and are not considered to limit this application. Additionally, throughout all the drawings, identical components are denoted by identical reference numerals. In the drawings:
FIG. 1 is a schematic diagram of a first structure of an energy storage practical training teaching aid according to an embodiment of this application;
FIG. 2 is a schematic diagram of a second structure of an energy storage practical training teaching aid according to an embodiment of this application;
FIG. 3 is a schematic diagram of a third structure of an energy storage practical training teaching aid according to an embodiment of this application;
FIG. 4 is a schematic diagram of a fourth structure of an energy storage practical training teaching aid according to an embodiment of this application;
FIG. 5 is a schematic diagram of a fifth structure of an energy storage practical training teaching aid according to an embodiment of this application;
FIG. 6 is a schematic diagram of a sixth structure of an energy storage practical training teaching aid according to an embodiment of this application;
FIG. 7 is a schematic diagram of a seventh structure of an energy storage practical training teaching aid according to an embodiment of this application; and
FIG. 8 is a schematic diagram of an eighth structure of an energy storage practical training teaching aid according to an embodiment of this application.

Reference signs: 10. energy storage device; 110. battery pack; 110A. simulated battery cell; 120. cooling unit; 130. control cabinet; 140. energy storage product cabinet; 1410. accommodation space; 20. control device; 210. input device; 220. battery voltage simulation device; 2210. isolation connection unit; 2220. control unit; 2230. conversion and output unit; 22310. digital-to-analog conversion group; 223110. digital-to-analog converter; 223120. operational amplifier; 230. display control unit; 240. storage unit; 250. display device; 30. test panel; 310. measurement terminal unit; 3110. measurement terminal; 320. fault setting unit; 3210. fault terminal; 330. bench; 3310. first panel; and 3320. second panel.

### DETAILED DESCRIPTION

The embodiments of the technical solution of this application will be described in detail below with reference to the accompanying drawings. The following embodiments are only used to more clearly illustrate the technical solution of this application and thus serve as examples, not to limit the scope of protection of this application.

Unless otherwise defined, all technical and scientific terms used herein have the same meaning as commonly understood by those skilled in the technical field of this application; the terms used herein are for the purpose of describing specific embodiments only and are not intended to limit this application; the terms "including" and "having" and any variations thereof in the specification, claims, and the above description of the accompanying drawings of this application are intended to cover non-exclusive inclusion.

In the description of the embodiments of this application, the technical terms "first," "second," and the like are used only to distinguish different objects and should not be understood as indicating or implying relative importance or implicitly indicating the number, specific order, or primary-secondary relationship of the indicated technical features. In the description of the embodiments of this application, "multiple" means two or more, unless explicitly and specifically defined otherwise.

Reference herein to "embodiment" means that a particular feature, structure, or characteristic described in connection with the embodiment may be included in at least one embodiment of this application. The appearance of this phrase in various places in the specification does not necessarily refer to the same embodiment, nor is it an independent or alternative embodiment mutually exclusive with other embodiments. Those skilled in the art explicitly and implicitly understand that the embodiments described herein may be combined with other embodiments.

In the description of the embodiments of this application, the term "and/or" merely describes an association relationship between associated objects, indicating that three relationships may exist, for example, A and/or B may indicate: A alone, A and B simultaneously, and B alone. Additionally, the character "/" herein generally indicates an "or" relationship between the associated objects before and after.

In the description of the embodiments of this application, the term "a plurality of" refers to two or more (including two), and similarly, "a plurality of groups" refers to two or more groups (including two groups), and "a plurality of pieces" refers to two or more pieces (including two pieces).

In the description of the embodiments of this application, the orientations or positional relationships indicated by technical terms such as "center," "longitudinal," "transverse," "length," "width," "thickness," "upper," "lower," "front," "rear," "left," "right," "vertical," "horizontal," "top," "bottom," "inner," "outer," "clockwise," "counterclockwise," "axial," "radial," and "circumferential" are based on the orientations or positional relationships shown in the accompanying drawings. They are used only to facilitate the description of the embodiments of this application and simplify the description, and do not indicate or imply that the referred device or element must have a specific orientation, be constructed or operated in a specific orientation, and thus should not be construed as limiting the embodiments of this application.

In the description of the embodiments of this application, unless explicitly specified and limited otherwise, technical terms such as "installation," "connection," "linkage," "fixation," and the like, should be understood in a broad sense, for example, as a fixed connection, a detachable connection, or an integral connection; it may be a mechanical connection or an electrical connection; it may be a direct connection or an indirect connection through an intermediary, or it may be the internal communication or interaction between two elements. Those skilled in the art can understand the specific meanings of the above terms in the embodiments of this application based on specific circumstances.

As an emerging automotive sector, new energy vehicles have experienced relatively rapid development in recent years. During this period, the demand for cultivating talents that match this development has also been increasing. As the core power source of new energy vehicles, technical training for batteries is particularly important. Therefore, there is an urgent need to provide a battery practical training teaching aid to facilitate the learning of batteries by students and improve the teaching experience and quality.

Existing energy storage practical training teaching aids generally adopt physical battery cells for teaching purposes. However, physical battery cells have characteristics of self-discharge and inconsistent single-cell discharge. During long-term storage, professional personnel are required to conduct timely maintenance; otherwise, single-cell imbalance will occur. In severe cases, phenomena such as swelling and electrolyte leakage will appear, which significantly reduce the safety and service life of the energy storage practical training teaching aid.

Based on the above issues, this application designs an energy storage practical training teaching aid that adopts simulated battery cells without injected electrolyte. The control device is used to perform voltage simulation on the simulated battery cells in the energy storage device, thereby simulating the voltage output of physical battery cells. This effectively avoids the problems existing in physical battery cells, including characteristics of self-discharge and inconsistent single-cell discharge. These problems would otherwise require professional personnel to conduct timely maintenance during long-term storage; if such maintenance is not performed, single-cell imbalance will occur. In severe cases, phenomena such as swelling and electrolyte leakage will appear, which significantly reduce the safety and service life of the energy storage practical training teaching aid. In this way, the maintenance cost of the energy storage practical training teaching aid is reduced, and the safety and service life of the energy storage practical training teaching aid are improved. Additionally, the energy storage practical training teaching aid designed in this solution is equipped with a test panel. A measurement terminal unit is reserved on the test panel, and external measurement devices can be connected via the measurement terminal unit to measure the voltage parameter information of any two simulated battery cells, thereby achieving the purpose of measurement practical training teaching. Furthermore, the test panel in this solution is further equipped with a fault setting unit. Through fault terminals of the fault setting unit, operators can set various fault conditions by themselves, thereby simulating fault scenarios of energy storage products.

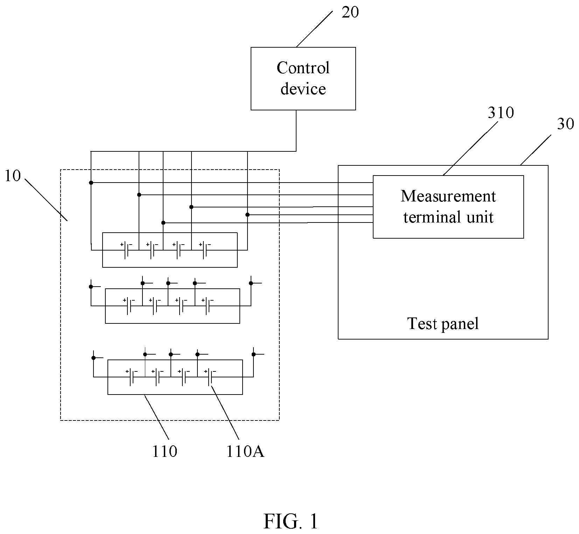

Based on the above concept, this application provides an energy storage practical training teaching aid, as shown in FIG. 1. The energy storage practical training teaching aid includes an energy storage device 10, a control device 20, and a test panel 30. The energy storage device 10 includes a plurality of battery packs 110, each battery pack 110 including a plurality of simulated battery cells 110A connected in series. The test panel 30 includes a measurement terminal unit 310, where the measurement terminal unit 310 and the control device 20 are both electrically connected to each simulated battery cell 110A, and the measurement terminal unit 310 is connected in parallel with the control device 20, that is, each simulated battery cell 110A is electrically connected to the measurement terminal unit 310 and the control device 20 in parallel, separately.

In the energy storage practical training teaching aid designed as described above, the control device 20 can control one or more target simulated battery cells in the energy storage device 10 to output a target required voltage in a simulated manner. Specifically, the control device 20 can receive a target required voltage input by an operator, respond to the input target required voltage signal, and output a pulse modulation signal with a target duty cycle corresponding to the target required voltage signal, thereby performing digital-to-analog conversion and amplification on the pulse modulation signal with the target duty cycle to output the target required voltage in a simulated manner. The target simulated battery cell(s) for which the control device 20 outputs the target required voltage in a simulated manner may be any one or more simulated battery cells in the energy storage device 10. When the control device 20 controls a plurality of simulated battery cells, the target required voltages simulated by different simulated battery cells may be the same or different.

In the energy storage practical training teaching aid, the measurement terminal unit 310 can connect to an external measurement device A (not shown in the figure). The external measurement device A can connect two target simulated battery cells through the measurement terminal unit 310, and then the external measurement device can collect electrical parameters between the two connected target simulated battery cells. The two connected target simulated battery cells may be any two simulated battery cells 110A in the energy storage device 10, and the electrical parameters may be information about the voltage across the two target simulated battery cells, and the like. The external measurement device A may specifically be any electrical measurement device, such as a multimeter or a voltage meter.

In the energy storage practical training teaching aid designed as described above, teaching staff can first use the control device 20 to control a plurality of simulated battery cells 110A in the energy storage device 10 to output different target required voltages in a simulated manner. Then, teaching staff or students can use an external measurement device to measure electrical parameters between two different target simulated battery cells through the measurement terminal unit 310 on the test panel 30, thereby achieving the purpose of practical training.

In the energy storage practical training teaching aid designed as described above, this solution adopts simulated battery cells without injected electrolyte. The control device is used to perform voltage simulation on the simulated battery cells in the energy storage device, thereby simulating the voltage output of physical battery cells. This effectively avoids the problems existing in physical battery cells, including characteristics of self-discharge and inconsistent single-cell discharge. These problems would otherwise require professional personnel to conduct timely maintenance during long-term storage; if such maintenance is not performed, single-cell imbalance will occur. In severe cases, phenomena such as swelling and electrolyte leakage will appear, which significantly reduce the safety and service life of the energy storage practical training teaching aid. In this way, the maintenance cost of the energy storage practical training teaching aid is reduced, and the safety and service life of the energy storage practical training teaching aid are improved. Additionally, the energy storage practical training teaching aid designed in this solution is equipped with a test panel. A measurement terminal unit is reserved on the test panel, and external measurement devices can be connected via the measurement terminal unit to measure the voltage parameter information of any two simulated battery cells, thereby achieving the purpose of measurement practical training teaching.

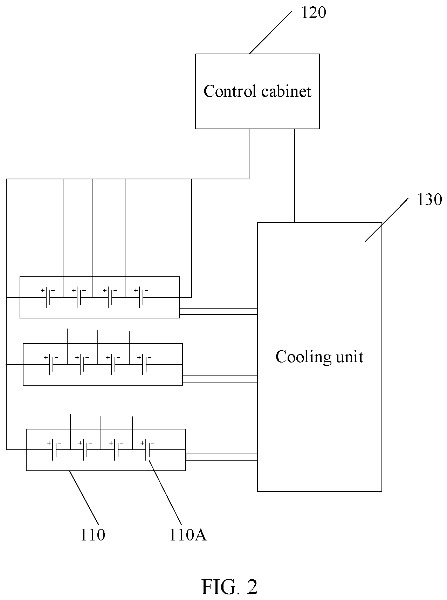

In an optional embodiment of this embodiment, as shown in FIG. 2, the energy storage device 10 designed in this solution further includes a cooling unit 120 and a control cabinet 130. The control cabinet 130 is electrically connected to the cooling unit 120 as well as to the simulated battery cells 110A of each battery pack 110, and the cooling unit 120 is connected to each battery pack 110 via cooling pipes. The cooling unit may specifically be a water-cooling unit or other types of cooling units, such as an air-cooling unit and an evaporative cooling unit, and the specific cooling type may be adaptively adjusted based on the actual application scenario.

In the energy storage device 10 designed as described above, the control cabinet 130 can monitor and acquire voltage information and temperature information of each simulated battery cell 110A. Specifically, a battery management system BMS can be integrated into the control cabinet 130. A voltage sensor is provided between the battery management system BMS and the connection line of each simulated battery cell, and a temperature sensor is provided around each simulated battery cell. In this way, the battery management system BMS acquires voltage information and temperature information of the simulated battery cells through the voltage sensors and temperature sensors. Additionally, the control cabinet 130, through its electrical connection with the cooling unit 120, can control the cooling unit 120. Specifically, it can control the cooling unit 120 to cool down a target battery pack through the cooling pipes. For example, when the control cabinet 130 detects that the temperature of a certain simulated battery cell or some simulated battery cells is high, the control cabinet 130 can control the cooling unit 120 to cool down the battery pack where the simulated battery cell(s) with high temperatures are located, so as to avoid the impact of temperature on the operation of the simulated battery cells or prevent fires due to high temperatures.

In the above embodiment, a control cabinet and a cooling unit are provided in the energy storage device 10 of this solution. When the energy storage device performs high-power discharge, the cooling unit can promptly dissipate heat generated by the battery pack, which stabilizes parameters such as output voltage and current of the battery, thereby improving the reliability and safety of the battery system.

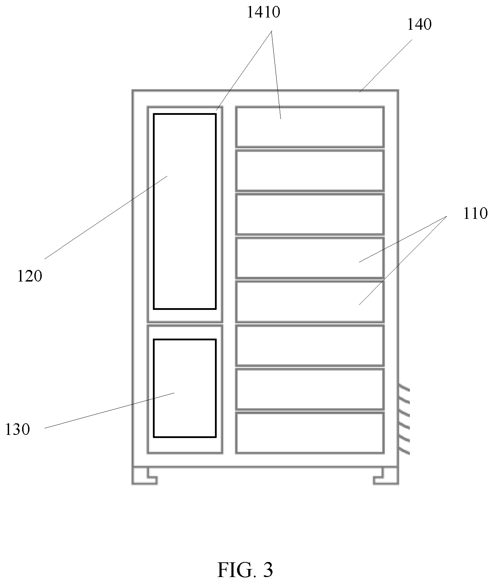

In an optional embodiment of this embodiment, as shown in FIG. 3, the energy storage device designed in this solution may further include an energy storage product cabinet 140, where the energy storage product cabinet 140 includes a plurality of accommodation spaces 1410, with the plurality of battery packs 110, the cooling unit 120, and the control cabinet 130 disposed within the plurality of accommodation spaces 1410. The layout of components in the energy storage product cabinet designed in this solution can be consistent with that of a physical energy storage device, thereby intuitively displaying the connection relationships of various components, facilitating analysis of the design and performance characteristics of battery series and parallel connections, the identification of the installation positions and characteristics of temperature sensors and voltage sensors, and the analysis of the detection principles of voltage and temperature data. For example, referring to FIG. 3, the energy storage product cabinet 140 designed in this solution may, like a physical energy storage device, include ten accommodation spaces, and a quantity of battery packs is eight. The cooling unit 120 and the control cabinet 130 are distributed in the two accommodation spaces on the left side of the energy storage product cabinet 140, and the eight battery packs are distributed in the eight accommodation spaces on the right side of the energy storage product cabinet 140.

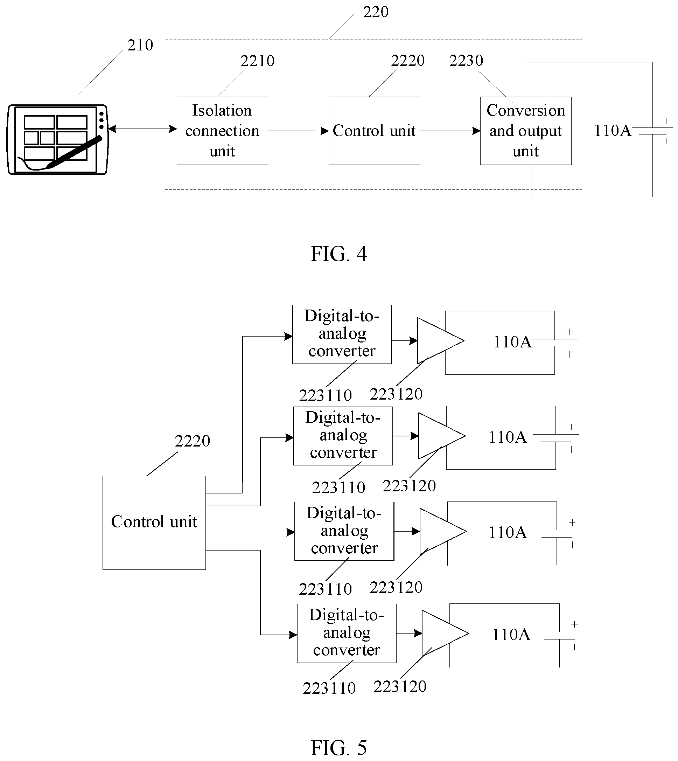

In an optional embodiment of this embodiment, as shown in FIG. 4, the control device 20 designed in this solution may include an input device 210 and a battery voltage simulation device 220, where the battery voltage simulation device 220 includes an isolation connection unit 2210, a control unit 2220, and a conversion and output unit 2230; where an input terminal of the isolation connection unit 2210 is electrically connected to the input device 210, an output terminal of the isolation connection unit 2210 is electrically connected to an input terminal of the control unit 2220, an output terminal of the control unit 2220 is electrically connected to an input terminal of the conversion and output unit 2230, and an output terminal of the conversion and output unit 2230 is electrically connected to the simulated battery cell 110A.

In the control device designed as described above, the isolation connection unit 2210 can also receive a required voltage signal transmitted by the input device 210, where the required voltage signal can be input through user operation of the input device 210, and the required voltage signal represents a digital signal that requires the simulated battery cell 110A to output a voltage in a simulated manner. For example, the required voltage signal is a digital signal with a voltage of 3 V.

The isolation connection unit 2210 can transmit the required voltage signal to the control unit 2220, and the control unit 2220 responds to the required voltage signal and outputs a pulse modulation signal with a target duty cycle to the conversion and output unit 2230. The control unit 2220 stores associations between different required voltage signals and corresponding duty cycles, with different required voltage signals corresponding to pulse modulation signals with different duty cycles. In this way, when a required voltage signal is received, the control unit 2220 can look up the target duty cycle corresponding to the required voltage signal and output the pulse modulation signal with the target duty cycle. As a possible implementation, the control unit 2220 may include a register, and the mapping relationship between different required voltage signals and corresponding duty cycles can be stored in the register. The control unit 2220 can obtain the target duty cycle corresponding to the required voltage signal by accessing and querying the register.

Specifically, this solution can pre-store combinations of required voltages and duty cycles (for example, higher bits representing the required voltages and lower bits representing the corresponding duty cycles) in binary encoding form in the register. The control unit 2220 can find, based on the required voltage signal (digital signal), the combination in the register that has the same digital value as the required voltage signal, so as to obtain the duty cycle in the lower bits of the combination and further obtain the target duty cycle.

After the control unit 2220 outputs the pulse modulation signal with the target duty cycle, the conversion and output unit 2230 can convert the pulse modulation signal with the target duty cycle into a corresponding voltage simulation signal, thereby enabling the simulated battery cell 110A to output the required voltage in a simulated manner. In this way, this solution can enable the simulated battery cell 110A to output different voltages in a simulated manner through the input device 210 and the battery voltage simulation device 220, so as to simulate the fault voltage of the battery cell and realize the teaching experiment of energy storage batteries. It should be noted that when the required voltage signal is input, this solution also allows selection of the simulated battery cell(s) that outputs the required voltage from a plurality of simulated battery cells 110A, specifically one or more simulated battery cells 110A can be selected. Specifically, different simulated battery cells can be distinguished by different identifiers or numbers, and operators only need to select simulated battery cells based on identifiers or numbers.

In this embodiment, the isolation connection unit 2210 may specifically include a CAN module and an isolation driver chip, with the isolation driver chip electrically connected to the input device 210 through the CAN module. The control unit 2220 may specifically adopt any microcontroller or CPU, such as models STM32F103 and, CS32F103.

As shown in FIG. 5, the conversion and output unit 2230 may include at least one digital-to-analog conversion group 22310, where each digital-to-analog conversion group 22310 includes one digital-to-analog converter 223110 and one operational amplifier 223120. An input terminal of the digital-to-analog converter 223110 of each digital-to-analog conversion group 22310 is electrically connected to an output terminal of the control unit 2220, an output terminal of the digital-to-analog converter 223110 of each digital-to-analog conversion group 22310 is connected to an input terminal of the operational amplifier 223120 of the corresponding digital-to-analog conversion group 22310, and an output terminal of each operational amplifier 223120 is configured to electrically connect to one simulated battery cell 110A.

In the above embodiment, the digital-to-analog converter is a component that converts digital signals into analog signals. In this application, the digital-to-analog converter 223110 can convert the pulse modulation signal with the target duty cycle (digital signal) transmitted by the control unit 2220 into a corresponding voltage simulation signal and transmit the voltage simulation signal to the corresponding connected operational amplifier 223120. The operational amplifier 223120 amplifies the voltage simulation signal and outputs the amplified voltage simulation signal, enabling the simulated battery cell 110A connected to the operational amplifier 223120 to output the required voltage in a simulated manner.

As a possible implementation, the digital-to-analog conversion groups 22310 may be provided in one, as shown in FIG. 4. In this case, the control unit 2220 designed in this solution can be electrically connected to one simulated battery cell 110A through one digital-to-analog converter 223110 and one operational amplifier 223120, thereby enabling the control unit 2220 to control the voltage simulation of only one simulated battery cell 110A individually.

As another possible implementation, as shown in FIG. 5, the digital-to-analog conversion groups 22310 designed in this solution may be provided in plurality (for example, four as shown in FIG. 5). In this case, the control unit 2220 designed in this solution can connect four digital-to-analog conversion groups 22310 simultaneously. This enables the control unit 2220 to simultaneously simulate and adjust the voltages of four simulated battery cells 110A.

In the above embodiment, the control unit designed in this solution can connect a plurality of digital-to-analog conversion groups simultaneously. This enables one control unit to simulate and adjust the voltage of a plurality of simulated battery cells simultaneously, thereby reducing the spatial distribution of components and saving the costs of component resources when voltage simulation is performed for the plurality of simulated battery cells.

Additionally, when the quantity of simulated battery cells set in this solution is large, to reduce the burden on the control unit 2220, this solution can set a plurality of battery voltage simulation devices 220, with each battery voltage simulation device 220 connecting to a certain quantity of simulated battery cells, thereby achieving simulation scenarios for a large quantity of battery packs.

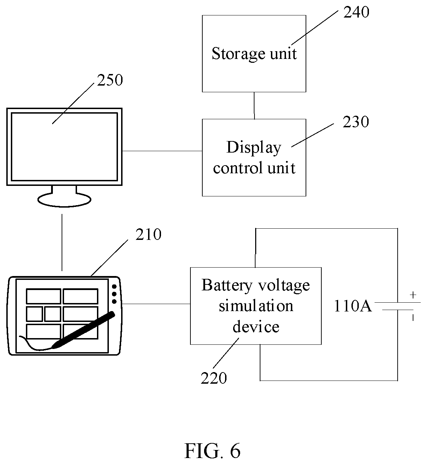

In an optional embodiment of this embodiment, as shown in FIG. 6, the control device 20 designed in this solution further includes a display control unit 230, a storage unit 240, and a display device 250. The display control unit 230 is electrically connected to the input device 210, the storage unit 240, and the display device 250, separately. The storage unit 240 pre-stores a circuit topology diagram of the energy storage device. The display control unit 230 can respond to a circuit diagram query request input by the input device 210, acquire the circuit topology diagram of the energy storage device stored in the storage unit 240, and display the circuit topology diagram of the energy storage device on the display device 250.

In the control device designed as described above, the storage unit 240 stores a circuit topology diagram that matches the physical energy storage device. During the teaching process, the circuit topology diagram can be displayed through the control device 20, thereby facilitating teaching and analysis of the circuit topology diagram.

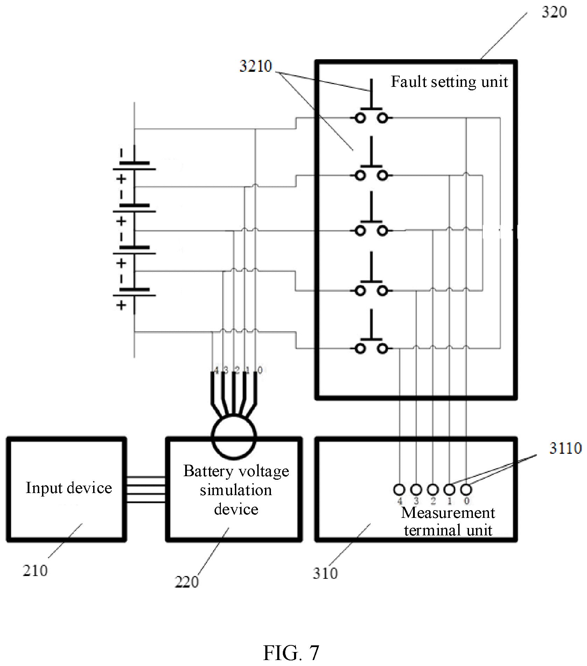

In an optional embodiment of this embodiment, as shown in FIG. 7, the measurement terminal unit 310 may include a plurality of measurement terminals 3110, each measurement terminal 3110 being electrically connected to a corresponding simulated battery cell 110A via a measurement line. Different measurement terminals 3110 connect to different simulated battery cells 110A. Specifically, each measurement terminal 3110 may be electrically connected to one simulated battery cell 110A via one measurement line, or each measurement terminal 3110 may be electrically connected to a plurality of simulated battery cells 110A via a plurality of measurement lines. The test panel 30 designed in this solution further includes a fault setting unit 320, where the fault setting unit 320 includes a plurality of fault terminals 3210, with one fault terminal 3210 provided on the circuit connection line between each simulated battery cell 110A and the control device 20. The fault terminal 3210 conducts the corresponding connected simulated battery cell and the control device 20 when in a closed state and disconnects the corresponding connected simulated battery cell from the control device 20 when in an open state.

In the test panel 30 designed as described above, operators set faults by operating the fault terminals 3210. For example, in this solution, a fault terminal can be pulled out to put it in an open state, thereby achieving an open-circuit fault between the simulated battery cell 110A connected to the fault terminal and the control device 20. For example, short-circuit faults can also be achieved by connecting the fault terminal to other constant power terminals using wires. Based on the fault settings, operators can further connect two different measurement terminals 3110 using an external measurement device A to perform electrical measurements between two simulated battery cells, so as to obtain electrical information between the simulated battery cells under fault conditions and further conduct fault analysis and teaching. Certainly, operators can also measure electrical information between two simulated battery cells under normal operating conditions using the external measurement device A.

In the above embodiment, through the arrangement of fault terminals in this solution, various fault types can be set in the energy storage practical training teaching aid designed in this solution. The fault types are comprehensive, which meets the teaching needs and aligns with real-world work scenarios. Moreover, the assessment difficulty can also be appropriately adjusted based on different teaching objects and teaching content.

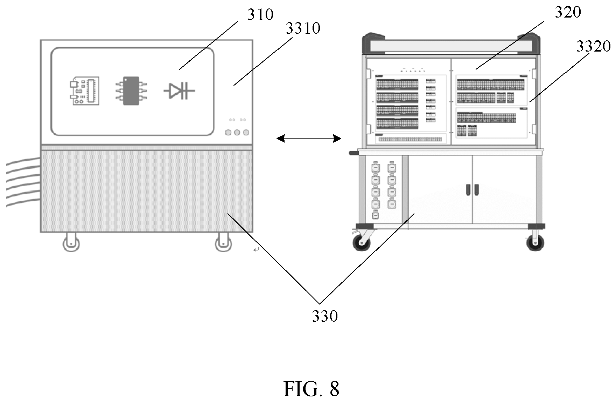

In an optional embodiment of this embodiment, as shown in FIG. 8, the test panel 30 designed in this solution may further include a bench 330, where the bench 330 may include a first panel 3310 and a second panel 3320, with the measurement terminal unit 310 disposed on the first panel 3310 and the fault setting unit 320 disposed on the second panel 3320.

In the above embodiment, the measurement terminal unit 310 on the first panel 3310 designed in this solution can be designed based on the physical energy storage cabinet and the original equipment manufacturer circuit diagram. The name and pin number of a simulated battery cell corresponding to each measurement terminal can be marked at the position of this measurement terminal on the first panel 3310, ensuring consistency with the physical objects and the original equipment manufacturer circuit diagram, thereby facilitating quick lookup and circuit analysis and improving practical training efficiency. Additionally, corresponding markings, that is, the name and pin number of a simulated battery cell corresponding to each fault terminal 3210, may also be made at the position of this fault terminal 3210 in the fault setting unit 320 on the second panel 3320. This ensures consistency with the physical objects and the original equipment manufacturer circuit diagram. Furthermore, both the measurement terminal unit 310 on the first panel 3310 and the fault setting unit 320 on the second panel 3320 can adopt a closed design, effectively preventing personnel and equipment damage due to incorrect operations and avoiding viewing fault points during training, thus reducing operational difficulty.

Finally, it should be noted that the above embodiments are only used to illustrate the technical solution of this application, not to limit it. Although this application has been described in detail with reference to the foregoing embodiments, those skilled in the art should understand that modifications can still be made to the technical solutions described in the foregoing embodiments, or equivalent replacements can be made to some or all of the technical features; such modifications or replacements do not cause the essence of the corresponding technical solutions to depart from the scope of the technical solutions of the embodiments of this application, and they should be included within the scope of the claims and the specification of this application. In particular, as long as there is no structural conflict, the technical features mentioned in each embodiment can be combined in any manner. This application is not limited to the specific embodiments disclosed herein but includes all technical solutions falling within the scope of the claims.

## Claims

1. An energy storage practical training teaching aid, **characterized in that** the energy storage practical training teaching aid comprises: an energy storage device, a control device, and a test panel; wherein the energy storage device comprises a plurality of battery packs, each battery pack comprising a plurality of simulated battery cells connected in series; and the test panel comprises a measurement terminal unit, the measurement terminal unit and the control device being both electrically connected to each simulated battery cell, and the measurement terminal unit being connected in parallel with the control device;
the measurement terminal unit is configured to connect to an external measurement device to collect electrical parameters between two target simulated battery cells connected to the external measurement device; and
the control device is configured to control one or more target simulated battery cells in the energy storage device to output a target required voltage in a simulated manner.

2. The energy storage practical training teaching aid according to claim 1, **characterized in that** the energy storage device further comprises a cooling unit and a control cabinet; wherein the control cabinet is electrically connected to the cooling unit as well as to the simulated battery cells of each battery pack, and the cooling unit is connected to each battery pack via cooling pipes; and
the control cabinet is configured to control the cooling unit to cool a target battery pack through the cooling pipes and to acquire voltage information and temperature information of each simulated battery cell.

3. The energy storage practical training teaching aid according to claim 2, **characterized in that** the energy storage device further comprises an energy storage product cabinet; wherein the energy storage product cabinet comprises a plurality of accommodation spaces, with the plurality of battery packs, the cooling unit, and the control cabinet disposed within the plurality of accommodation spaces.

4. The energy storage practical training teaching aid according to claim 1, **characterized in that** the control device comprises an input device and a battery voltage simulation device; wherein the battery voltage simulation device comprises an isolation connection unit, a control unit, and a conversion and output unit;
an input terminal of the isolation connection unit is electrically connected to an input device, an output terminal of the isolation connection unit is electrically connected to an input terminal of the control unit, an output terminal of the control unit is electrically connected to an input terminal of the conversion and output unit, and an output terminal of the conversion and output unit is electrically connected to the simulated battery cell;
the isolation connection unit is configured to: electrically isolate the control unit from the input device, receive a target required voltage signal transmitted by the input device, and transmit the target required voltage signal to the control unit;
the control unit is configured to output a pulse modulation signal with a target duty cycle to the conversion and output unit in response to the target required voltage signal; wherein different required voltage signals correspond to pulse modulation signals with different duty cycles; and
the conversion and output unit is configured to convert the pulse modulation signal with the target duty cycle into a corresponding voltage simulation signal, the voltage simulation signal representing the target required voltage that is output by the connected simulated battery cell in a simulated manner.

5. The energy storage practical training teaching aid according to claim 4, **characterized in that** the conversion and output unit comprises at least one digital-to-analog conversion group; wherein each digital-to-analog conversion group comprises one digital-to-analog converter and one operational amplifier, an input terminal of the digital-to-analog converter of each digital-to-analog conversion group is electrically connected to an output terminal of the control unit, an output terminal of the digital-to-analog converter of each digital-to-analog conversion group is connected to an input terminal of the operational amplifier of the corresponding digital-to-analog conversion group, and an output terminal of each operational amplifier is configured to electrically connect to one simulated battery cell;
the digital-to-analog converter is configured to convert the pulse modulation signal with the target duty cycle into a corresponding voltage simulation signal and transmit the voltage simulation signal to the operational amplifier; and
the operational amplifier is configured to amplify the voltage simulation signal and output the amplified voltage simulation signal to make the corresponding connected simulated battery cell output the target required voltage.

6. The energy storage practical training teaching aid according to claim 5, **characterized in that** the digital-to-analog conversion group is provided in plurality; and each digital-to-analog conversion group is connected to a corresponding simulated battery cell.

7. The energy storage practical training teaching aid according to claim 4, **characterized in that** the control device further comprises a display control unit, a storage unit, and a display device; wherein the display control unit is electrically connected to the input device, the storage unit, and the display device, separately; and
the display control unit is configured to: respond to a circuit diagram query request input by the input device, acquire a circuit topology diagram of the energy storage device stored in the storage unit, and display the circuit topology diagram of the energy storage device on the display device; wherein the storage unit pre-stores the circuit topology diagram of the energy storage device.

8. The energy storage practical training teaching aid according to claim 1, **characterized in that** the measurement terminal unit comprises a plurality of measurement terminals, with each measurement terminal electrically connected to a corresponding simulated battery cell via a measurement line.

9. The energy storage practical training teaching aid according to claim 1, **characterized in that** the test panel further comprises a fault setting unit; wherein the fault setting unit comprises a plurality of fault terminals, with one fault terminal provided on a circuit connection line between each simulated battery cell and the control device; and
the fault terminal is configured to conduct the corresponding connected simulated battery cell and the control device when in a closed state and to disconnect the corresponding connected simulated battery cell from the control device when in an open state.

10. The energy storage practical training teaching aid according to claim 9, **characterized in that** the test panel further comprises a bench, wherein the bench comprises a first panel and a second panel opposite the first panel, the measurement terminal unit is disposed on the first panel, and the fault setting unit is disposed on the second panel.
